# FASCICULE DE BREVET EUROPEEN

(11) **EP 3 500 079 B1**
(45) Date de publication et mention de la délivrance du brevet: **29.09.2021**
(21) Numéro de dépôt: 18211441.3
(22) Date de dépôt: 10.12.2018
(51) Int. Cl.: H05K 7/20

(54) **SYSTÈME DE REFROIDISSEMENT LIQUIDE POUR CARTE ÉLECTRONIQUE CONSTITUÉE D'UNE PLAQUE FROIDE ET DE DISSIPATEURS THERMIQUES RELIES EN LIAISONS SOUPLES AVEC LADITE PLAQUE FROIDE**
FLÜSSIGKEITSKÜHLUNGSSYSTEM FÜR EINE ELEKTRONIKPLATTE ENTHALTEND EINE KALTPLATTE UND KÜHLKÖRPER, DIE MIT DIESER ÜBER FLEXIBLE VERBINDUNGEN VERBUNDEN SIND
LIQUID COOLING SYSTEM FOR AN ELECTRONIC BOARD COMPRISING A COLD PLATE AND HEAT SINKS LINKED TO COLD PLATE USING FLEXIBLE LINKS

(30) Priorité: 15.12.2017 FR 1762254
(43) Date de publication de la demande: 19.06.2019
(73) Titulaire: Bull SAS, 78340 Les Clayes-sous-Bois (FR)
(72) Inventeur: RAETH, Marc, 78910 Tacoignieres (FR)
(74) Mandataire: Novagraaf Technologies

(56) Documents cités:
- EP-A1- 2 770 810
- US-A1- 2005 241 799
- US-A1- 2009 294 106

## Description

La présente invention concerne un système de refroidissement liquide d'une carte électronique comprenant au moins un processeur de calcul.

Les lames de calcul pour serveur comportent généralement des cartes électroniques qui dégagent de la chaleur et doivent donc être refroidies. Initialement, ces cartes électroniques étaient refroidies par de l'air. Toutefois, dans le cas de serveurs montables sur bâti, la circulation d'air n'est pas suffisante pour refroidir les cartes électroniques.

Pour résoudre ce problème, des systèmes de refroidissement fluidiques ont été développés.

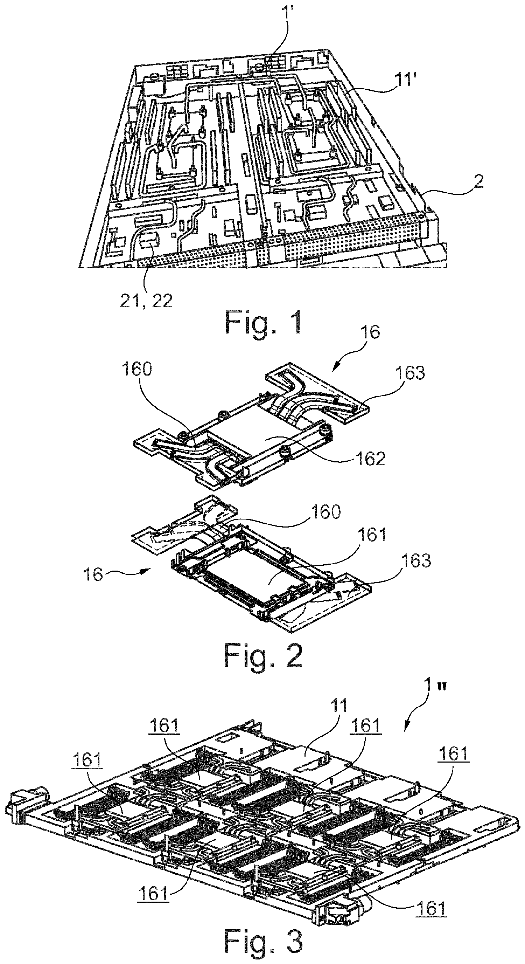

Parmi les solutions connues de refroidissement de cartes électroniques, la société IBM a mis au point un système de refroidissement mixte 1' de cartes électroniques 2 double processeurs pour supercalculateur, qui est représenté sur la figure 1. Un tel système comporte des tuyaux en cuivre 11' contenant un liquide caloporteur formant une boucle liquide. Toutefois, la rigidité des tuyaux en cuivre 11' ne permet pas le démontage rapide d'un unique processeur. En outre, la boucle liquide assure le refroidissement des processeurs uniquement. Le reste de la puissance dissipée est refroidie par convection dans l'air, ce qui n'est pas optimal pour l'efficacité énergétique (PUE, acronyme désignant en anglais « *Power Usage Effectiveness* ») du supercalculateur.

D'autres fabricants de cartes électroniques proposent des systèmes de refroidissement liquides dédiés uniquement aux processeurs. Ces derniers intègrent un dissipateur thermique, une pompe intégrée et un échangeur pour extraire les calories. Bien entendu, de tels dispositifs ne sont pas compatibles à des systèmes de plus grande échelle comme les supercalculateurs pour raison d'encombrement.

Le demandeur a mis au point, par ailleurs, un système de refroidissement 1" mixte (illustré sur la figure 3) dans lequel les cartes électroniques 2 sont refroidies par l'intermédiaire d'une plaque froide 11 en aluminium dans laquelle circule un liquide caloporteur, la plaque froide 11 étant interfacée avec tous les composants électroniques bas et moyens à refroidir, c'est-à-dire l'ensemble des composants d'une carte électronique 3 à l'exclusion des composants électroniques hauts (typiquement les processeurs et les barrettes mémoires). Les processeurs 23 (non visibles sur la figure 3) sont les composants les plus contraignants à refroidir (car ils doivent rester accessibles) et aussi les plus dissipatifs. Ils ne peuvent pas être interfacés avec la plaque froide 11 directement. Afin d'assurer le contact thermique avec les processeurs 23, chacun d'eux est interfacé avec un dissipateur thermique intermédiaire 16 à caloducs 160 (illustré sur la figure 2). Il s'agit d'un dissipateur thermique 16 diphasique à changement de phase (généralement désigné en anglais par les termes « *Heat Spreader CPU* »), qui conduit la chaleur des processeurs 23 vers la plaque froide 11. La partie des caloducs 160 en contact avec la dalle en cuivre qui interface le processeur 23 constitue l'évaporateur 162, tandis que celle en contact avec l'interface avec la plaque froide 11 constitue le condenseur 163. Cette solution est décrite de manière plus détaillée dans les demandes de brevet européen EP 2770809 et EP 2770810 appartenant au Demandeur.

Cette solution de refroidissement des processeurs à l'aide de caloducs présente également des inconvénients, et en particulier :
- des limites thermiques spécifiques aux caloducs : l'écoulement à l'intérieur d'un caloduc est diphasique et est régi par cinq limites en termes d'écoulement, de viscosité, d'ébullition, d'entrainement, de capillarité) qui dépendent des dimensions des caloducs et de la puissance à évacuer.
- des limites mécaniques : l'augmentation du nombre de caloducs entraine une augmentation de la rigidité de l'ensemble. Or, afin de compenser les écarts de tolérances il est indispensable que le dissipateur se déforme suffisamment.
- un nombre élevé d'interfaces thermiques amovibles : des contacts thermiques doivent être assurés entre la plaque froide et le dissipateur thermique d'une part, et entre le dissipateur thermique et le processeur. Ces contacts thermiques sont dans la solution actuelle mise en place par le demandeur garantis par l'utilisation de graisse conductrice, présentant l'inconvénient de générer un gradient de température élevé.
- la complexité et le coût de la solution globale : les surfaces d'échanges solide/fluide sont actuellement au niveau de la plaque froide. La complexité de celle-ci au niveau des dissipateurs thermiques augmente considérablement les usinages dans la plaque froide et ainsi le coût de fabrication.

Pour résoudre les défauts et inconvénients susmentionnés, le déposant a donc mis au point un système de refroidissement pour une carte électronique qui est entièrement liquide, comprenant une plaque froide alimentée en fluide caloporteur via un chemin d'eau interne à la plaque froide, et une pluralité de dissipateurs thermiques reliés en liaisons souples avec le chemin d'eau interne à la plaque froide. Ces liaisons souples forment un réseau flexible couplé au réseau de canaux rigides de la plaque froide alimenté en fluide caloporteur (typiquement de l'eau glycolée), permettant ainsi l'alimentation en fluide caloporteur des dissipateurs thermiques. Ce réseau devra être couplé au système de plaque froide permettant le refroidissement du reste de la carte électronique.

Pour optimiser au maximum le refroidissement du processeur, le liquide caloporteur doit être amené au plus proche de la source de chaleur. A cette fin, le Demandeur a mis spécifiquement au point un dissipateur thermique monophasique comportant un bloc de refroidissement en matériau thermoconducteur pouvant être alimenté en fluide caloporteur. La source de chaleur que constitue le processeur sera donc directement interfacée avec ce bloc de *refroidissement* (*également désigné dans les exemples par le terme en anglais « waterblock* ») alimenté en fluide caloporteur prélevé de la plaque froide. Un tel système de refroidissement intégré répond aux contraintes d'efficacité thermiques, de compacité mécanique et de maintenabilité nécessaire pour ce type de matériel informatique haute performance.

Plus particulièrement, la présente invention a donc pour objet un système de refroidissement liquide d'une carte électronique comprenant un support, une pluralité de composants électroniques fixés sur ledit support se décomposant en composants électroniques bas et moyens et en composants électroniques hauts (de préférence des processeurs), ledit système comprenant :
- une plaque froide présentant des dimensions extérieures sensiblement égales à celles dudit support de la carte électronique de sorte qu'elle recouvre l'intégralité du support et lesdits composants électroniques bas et moyens, ladite plaque froide étant une plaque réalisée en un matériau thermique conducteur et comprenant un circuit primaire de refroidissement avec des canaux principaux (de préférence rigides) à l'intérieur desquels circule un fluide caloporteur, l'alimentation en fluide caloporteur dans ladite plaque froide étant réalisée via un connecteur d'entrée et la sortie dudit fluide caloporteur hors de la plaque froide se faisant via un connecteur de sortie,
- une pluralité de dissipateurs thermiques comprenant chacun une zone d'échange thermique principale apte à venir en appui contre un composant électronique haut,
ledit système de refroidissement liquide étant caractérisé en ce qu'il comporte en outre un circuit secondaire de canaux secondaires flexibles connectés aux canaux principaux du circuit primaire par des connecteurs coudés fixés dans ladite plaque froide (par exemple par vissage dans la plaque froide), et
en ce que lesdits dissipateurs thermiques (12) sont des dissipateurs thermiques monophasiques qui comprennent chacun :
▪ un bloc de refroidissement en matériau thermoconducteur (typiquement en aluminium ou alliage d'aluminium) comprenant une partie inférieure constituant la zone d'échange thermique principale, une partie intermédiaire dite de répartition et une partie supérieure connectée à la plaque froide,
▪ un canal d'entrée et un canal de sortie qui sont connectés d'une part à la partie supérieure dudit bloc de refroidissement par l'intermédiaire respectivement d'un connecteur d'entrée et d'un connecteur de sortie, et d'autre part à un canal secondaire flexible du circuit secondaire via un connecteur coudé, de sorte que ledit bloc de refroidissement est alimenté par ledit fluide caloporteur circulant dans ladite plaque froide, lesdits connecteurs coudés étant aptes à permettre la rotation desdits canaux d'entrée et de sortie par rapport audit canal secondaire flexible auquel ils sont connectés, et
en ce que ledit bloc de refroidissement comprend en outre:
▪ une fente traversante située dans la partie intermédiaire pour répartir de manière homogène l'écoulement dudit fluide caloporteur en provenance de la partie supérieure sous forme de jet centré vers
▪ une plaque support située dans la zone d'échange thermique principale et comportant une partie centrale creuse avec une zone munie d'ailettes ou de picots pour générer de la turbulence dans le régime d'écoulement dudit fluide caloporteur et une zone périphérique à ladite zone munie d'ailettes ou de picots pour recueillir le fluide caloporteur et le diriger vers ledit connecteur de sortie.

Le système de refroidissement selon l'invention permet ainsi de garantir le refroidissement de tous les composants de la carte électronique, et ce par voie liquide quelle que soit la nature des composants électroniques : les composants bas et moyens par la plaque froide et les composants dits hauts tels que les processeurs et les barrettes mémoires par les dissipateurs thermiques monophasiques à bloc de refroidissement.

Par composants électroniques bas et moyens, on entend, au sens de la présente invention, tout composant de la carte électronique présentant une hauteur inférieure à une hauteur seuil, au-dessous de laquelle il peut être refroidi par le circuit de refroidissement la plaque froide. Pour ce qui concerne les composants électroniques bas et moyens, il s'agit en général d'alimentation ou de régulateur de tension.

Par composants électroniques hauts, on entend, au sens de la présente invention, tout composant de la carte électronique qui n'est pas refroidi par le circuit de refroidissement la plaque froide car ils doivent rester accessibles sans démontage de la plaque froide. Il s'agit de composants électroniques nécessitant une maintenance rapide comme les processeurs ou les barrettes mémoires.

Le système de refroidissement selon l'invention, en raison de sa structure avec blocs de refroidissement reliés en liaisons souples avec le circuit de refroidissement de la plaque froide, permet une grande flexibilité pour le démontage des processeurs et garantit une fiabilité des connexions après un grand nombre de cycles d'opération de démontage. Une étanchéité à 10 bars est garantie par le système de refroidissement selon l'invention, y compris après plusieurs opération de démontage.

Le système de refroidissement selon l'invention, en raison de sa structure avec blocs de refroidissement reliés en liaisons souples avec le circuit de refroidissement de la plaque froide, permet l'implantation d'une pluralité de dissipateurs de chaleur en série ou en parallèle, par exemple au nombre de six.

Le dissipateur thermique du système de refroidissement selon l'invention doit d'ailleurs lui-même respecter une contrainte d'encombrement défini par la taille des processeurs et par la place disponible sur les plaques froides pour répartir judicieusement le fluide de refroidissement.

Le dissipateur thermique du système de refroidissement selon l'invention permet en outre de répondre à des contraintes de fabrication en grande série, en raison de sa simplicité de fabrication et d'assemblage par liaisons souples avec la plaque froide.

La partie intermédiaire du bloc de refroidissement comporte une fente. Dans cette configuration, le fluide caloporteur, lorsqu'il arrive dans le bloc de refroidissement, traverse une fine fente très fine ou lame, qui permet sa répartition équitable dans la surface d'échange au travers des ailettes. La forme de ce répartiteur et sa distance par rapport aux ailettes sont étudiés de manière à obtenir un nombre de Reynolds le plus grand possible dans l'encombrement disponible.

De préférence, on choisira d'orienter la fente de la partie intermédiaire du bloc de refroidissement perpendiculairement à la direction des ailettes, de manière à maximiser le coefficient d'échange entre le fluide et la surface solide des ailettes.

Selon un mode de réalisation avantageux du bloc de refroidissement, la partie intermédiaire du bloc de refroidissement peut être constituée d'une plaque de répartition dans laquelle est pratiquée la fente traversante.

Dans un tel mode de réalisation, la plaque de répartition peut se présenter sous la forme sensiblement d'un parallélépipède rectangle dont l'un des côtés est muni d'une marche s'emboitant dans la partie de la zone périphérique de la zone d'échange thermique principale est située sous le connecteur d'entrée sans recouvrir la partie de la zone périphérique sous ledit connecteur de sortie.

Selon un mode de réalisation avantageux du bloc de refroidissement, on utilisera pour la plaque support du bloc de refroidissement des ailettes, et de préférence des ailettes droites. Dans ce cas, les ailettes droites peuvent présenter une épaisseur de 0,2 mm et être espacées les unes des autres d'une distance de 0,4 mm. L'écart entre 2 ailettes est de préférence de 0,2 mm également.

L'utilisation d'ailettes permet d'une part d'augmenter la surface d'échange, et d'autre part d'augmenter la turbulence de l'écoulement pour améliorer le coefficient d'échange thermique.

Les ailettes droites permettent de créer un écoulement par jet (connu sous la dénomination en anglais « *liquid-jet* ») et d'obtenir des régimes d'écoulements turbulents même avec des vitesses et des pertes de pression très faibles.

Le système de refroidissement liquide selon l'invention permet donc de combiner une surface d'échange élevée et un coefficient convectif optimisé au centre du processeur grâce à son écoulement par jet centré. Il permet en outre d'obtenir une réduction du diamètre hydraulique et des sections de passage, ce qui offre une plus grande vitesse au fluide et ainsi les échanges convectifs sont améliorés. Ce type d'écoulement permet aussi de centrer le pic du transfert de chaleur convectif contrairement aux écoulements longitudinaux, qui n'optimisent pas l'échange au plus proche du processeur.

D'autres avantages et particularités de la présente invention résulteront des exemples ci-après qui va suivre, donnés à titre d'exemple non limitatif et en référence aux figures annexées :
- la figure 1 montre un système de refroidissement mixte d'une carte électronique double processeur de l'art antérieur;
- la figure 2 un dissipateur thermique diphasique d'un système de refroidissement de carte électronique connu de l'art antérieur et appartenant au Demandeur,
- la figure 3 montre le système de refroidissement connu de l'art antérieur intégrant le dissipateur thermique illustré sur la figure 2,
- la figure 4 est une représentation schématique du système de refroidissement liquide selon l'invention, montrant la répartition du fluide caloporteur dans les canaux secondaires flexibles au travers des dissipateurs thermiques ;
- la figure 5 est une photographie montrant, dans un système de refroidissement liquide selon l'invention comportant une pluralité de ces blocs de refroidissement, la cinématique de rotation de l'un de ces blocs par rapport à un canal du circuit secondaire de refroidissement
- la figure 6 est une vue éclatée schématique d'un mode de réalisation d'un dissipateur thermique utilisable dans un système de refroidissement liquide selon l'invention ;
- la figure 7 est une photographie montrant le montage complet du système de refroidissement liquide selon l'invention sur trois cartes électroniques comportant chacune un processeur ;
- La figure 8 montre le résultat d'une simulation numérique de l'évolution de la perte de charge dans le circuit de refroidissement primaire de la plaque froide, faisant partie d'un système de refroidissement liquide selon l'invention à 3 blocs de refroidissement ;
- la figure 9 est une représentation schématique du modèle hydraulique simplifié du système de refroidissement liquide selon l'invention correspondant à celui pour lequel la simulation numérique illustrée sur la figure 9 a été réalisée ;
- La figure 10 montre le résultat d'une simulation numérique de l'évolution du champ de vitesses dans le circuit de refroidissement primaire de la plaque froide, faisant partie d'un système de refroidissement liquide selon l'invention correspondant à celui des figures 9 et 10 ;
- La figure 11 montre le résultat d'une simulation numérique de l'échauffement du fluide caloporteur dans le circuit de refroidissement primaire de la plaque froide, faisant partie d'un système de refroidissement liquide selon l'invention correspondant à celui des figures 9, 10 et 11 ; dans cette figure on observe également l'échauffement du fluide dans les tuyaux représentatif du bloc de refroidissement ;
- La figure 12 montre le résultat du champ de températures de la plaque froide (vue de dessous, c'est-à-dire du côté de la carte électronique).

Pour plus de clarté, les éléments identiques ou similaires sont repérés sur ces figures par des signes de références identiques sur l'ensemble des figures.

Les figures 1 à 3 sont décrites plus en détail au niveau de la partie de la description qui précède, relative à la description des solutions connues de l'art antérieur.

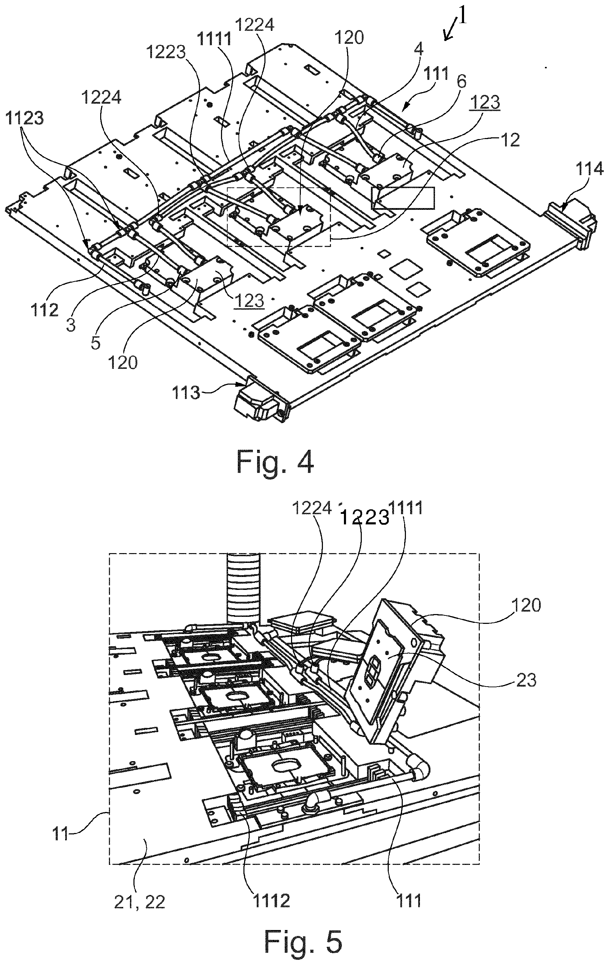

Les figures 4 à 8 sont décrites plus en détail au niveau de la partie de la description qui suit, relative à la description détaillée d'un mode de réalisation du système de refroidissement liquide selon l'invention.

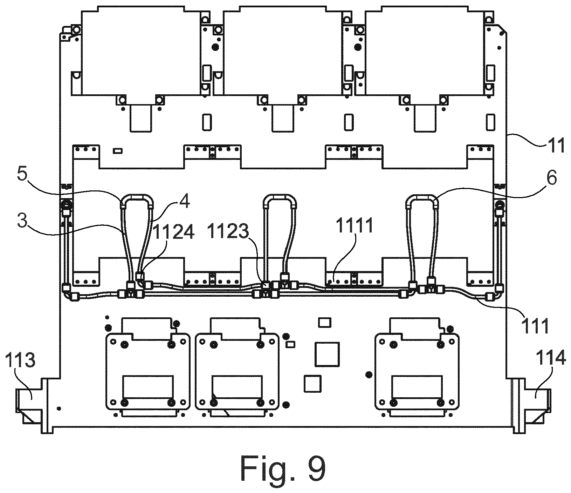

Les figures 9 à 14 sont décrites plus en détail au niveau des exemples qui suivent, qui illustrent l'invention sans en limiter la portée.

### DESCRIPTION D'UN MODE DE REALISATION

La figure 4 représente schématiquement un mode de réalisation d'un système de refroidissement liquide 1 selon l'invention comportant trois dissipateurs thermiques 12. La figure 4 montre plus particulièrement distribution du fluide caloporteur 112 dans un réseau secondaire de canaux secondaires flexibles 1111 au travers des dissipateurs thermiques 12.

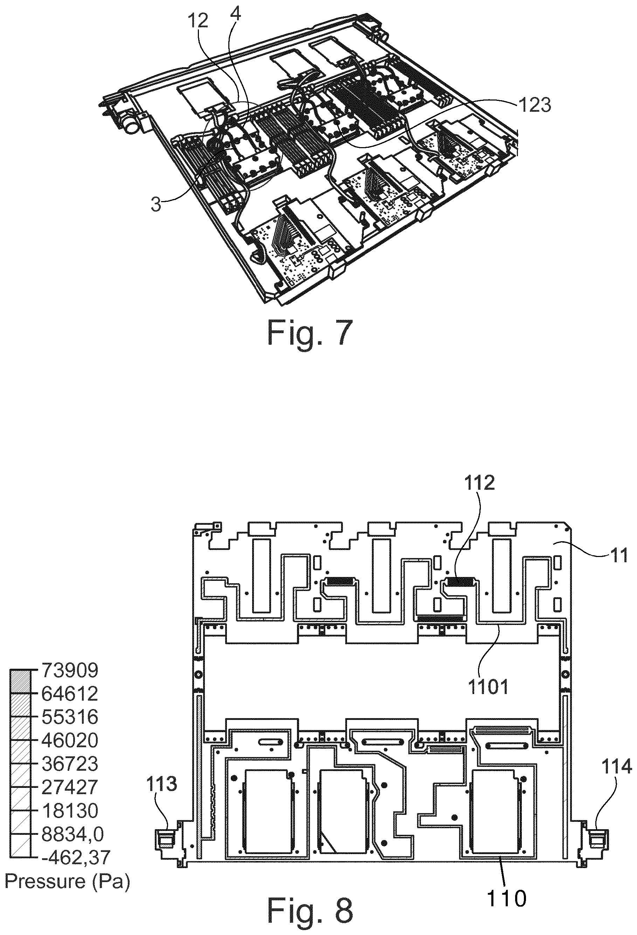

Le montage complet du système de refroidissement liquide 1 selon l'invention sur une carte électronique 2 comportant trois processeurs 23 (visibles sur la figure 5) est montré sur la photographie de la figure 8. La carte électronique 2 comprend, outre les processeurs 23, une pluralité de composants électroniques bas et moyens 22 (visibles par transparence sur la figure 5) fixés sur un support 21.

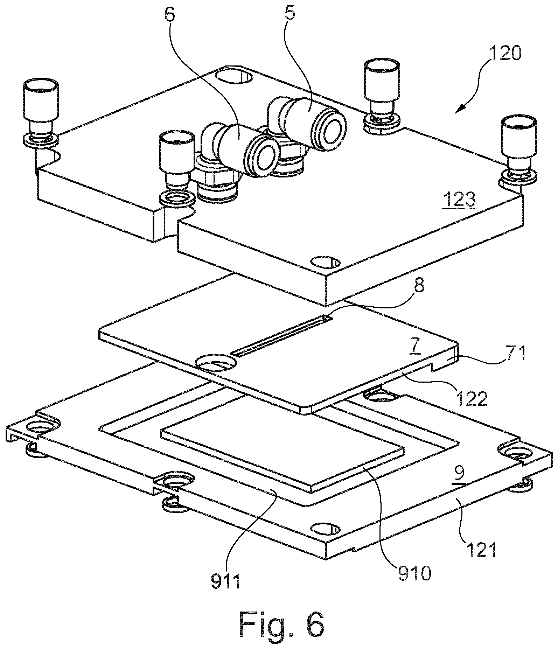

La figure 8 montre que le système de refroidissement liquide selon l'invention comprend d'une part une plaque froide 11 présentant des dimensions extérieures sensiblement égales à celles dudit support de la carte électronique 2 de sorte qu'elle recouvre l'intégralité du support 21 et des composants électroniques bas et moyens 22 qui y sont fixés, et d'autre part trois dissipateurs thermiques 12 comprenant chacun une zone d'échange thermique principale 121 (visible sur la figure 6) apte à venir en appui contre un processeur 23.

La plaque froide 11 peut être avantageusement une plaque réalisée en un matériau thermique conducteur tel que l'aluminium. Elle comprend un circuit primaire de refroidissement 110 (visible sur la simulation de la figure 8) avec des canaux principaux 1101 à l'intérieur desquels circule un fluide caloporteur 112 tel que de l'eau glycolée. L'alimentation en fluide caloporteur 112 dans la plaque froide 11 est réalisée via un connecteur d'entrée 113 et la sortie du fluide caloporteur 112 hors de la plaque froide 11 se faisant via un connecteur de sortie 114.

La figure 5 montre par ailleurs comment le système de refroidissement liquide 1 selon l'invention est associé au circuit primaire de refroidissement 110 de la plaque froide, grâce à des dissipateurs thermiques monophasiques 12 (visibles également sur la figure 4) et un circuit secondaire 111 de canaux secondaires flexibles 1111 connectés aux canaux principaux 1101 du circuit primaire 110 par des connecteurs coudés 1112 vissés dans la plaque froide 11.

Les dissipateurs thermiques 12 sont des dissipateurs thermiques monophasiques qui comprennent chacun (voir également la figure 4) :
▪ un bloc de refroidissement 120 en matériau thermoconducteur
▪ un canal d'entrée 3 et un canal de sortie 4 qui sont connectés d'une part à la partie supérieure 123 dudit bloc de refroidissement 120 par l'intermédiaire respectivement d'un connecteur d'entrée 5 et d'un connecteur de sortie 6, et d'autre part à un canal secondaire flexible 1111 du circuit secondaire 111 via un connecteur coudé 1223, 1224.

La structure du dissipateur thermique du système de refroidissement selon l'invention est donc telle que le bloc de refroidissement est alimenté par le fluide caloporteur 112 circulant dans ladite plaque froide 11.

La figure 5 montre clairement que ces connecteurs coudés 1223, 1224 permettent la rotation des canaux d'entrée et de sortie 3, 4 par rapport au canal secondaire flexible 1111 auquel ils sont connectés.

La figure 6 est une vue éclatée schématique d'un mode de réalisation d'un dissipateur thermique 12 utilisable dans un système de refroidissement liquide 1 selon l'invention. Cette figure montre que le dissipateur thermique utilisable dans le cadre de l'invention comprend un bloc de refroidissement 120 en matériau thermoconducteur comprenant une partie inférieure constituant une zone d'échange thermique principale 121, une partie intermédiaire 122 dite de répartition et une partie supérieure 123 connectée à la plaque froide 11. Une fente traversante 8 est située dans la partie intermédiaire 122 pour répartir de manière homogène l'écoulement du fluide caloporteur 112 en provenance de la partie supérieure 123 sous forme de jet centré vers une plaque support 9 située dans la zone d'échange thermique principale 121. Cette plaque support 9 et comportant une partie centrale creuse avec une zone munie d'ailettes 910 (les ailettes ne sont pas visibles sur la fig.6) pour générer de la turbulence dans le régime d'écoulement dudit fluide caloporteur 112 et une zone périphérique 911 à la zone munie d'ailettes 910 pour recueillir le fluide caloporteur 112 et le diriger vers ledit connecteur de sortie 6.

Selon un mode de réalisation avantageux du bloc de refroidissement, on utilisera pour la plaque support du bloc de refroidissement des ailettes 910, et de préférence: des ailettes droites. Dans ce cas, les ailettes droites peuvent présenter une épaisseur de 0,2 mm et être espacées les unes des autres d'une distance de 0,4 mm.

Selon un mode de réalisation avantageux du bloc de refroidissement, la fente traversante 8 est perpendiculaire à la direction des ailettes 910.

Selon un mode de réalisation avantageux du bloc de refroidissement, la partie intermédiaire 122 est constituée d'une plaque de répartition 7 dans laquelle est pratiquée la fente traversante 8. La plaque de répartition 7 se présente sous la forme sensiblement d'un parallélépipède rectangle dont l'un des côtés est muni d'une marche 71 s'emboitant dans la partie de la zone périphérique 911 de la zone d'échange thermique principale 121 située sous le connecteur d'entrée 5, sans recouvrir la partie de la zone périphérique 911 située sous le connecteur de sortie 6.

Grâce au système de refroidissement liquide selon l'invention 1, les processeurs seront 10°C moins chauds que si l'on utilisait le système de refroidissement connu de l'art antérieur représenté sur la figure 3 (système à caloducs : voir également la figure 2) à caloducs. Grâce au système de refroidissement liquide selon l'invention, il est donc possible de refroidir des processeurs plus puissants.

### EXEMPLES

On simule le comportement hydraulique du système de refroidissement liquide selon l'invention (à trois processeurs) tel que représenté sur les figures 4 à 8.

### CONDITIONS DE CALCUL

Les conditions de calculs sont les suivantes :
- Modèle simulant la conduction et la convection avec le fluide caloporteur, la convection naturelle et le rayonnement avec l'air ambiant autour de la plaque froide étant négligés ;
- Débit entrée de lame = 3 l/min (5.10⁻⁵ m³/s);
- Température du fluide caloporteur en entrée de lame = 44°C ;
- Fluide caloporteur utilisé : PEG MB633 (mélange eau + PEG)
Cibles de perte de charges pour équilibrage des lames : 70kPa Cible de ΔT_{entrée-sortie} sur la lame : environ 7°C

### EXEMPLE 1 : simulation hydraulique du système de refroidissement selon l'invention à 3 blocs de refroidissement (tel que représenté sur les figures 4 à 7).

Le résultat de la simulation numérique de l'évolution de la perte de charge dans le circuit de refroidissement primaire de la plaque froide est montré sur la figure 8. Un travail d'optimisation a permis d'atteindre la cible de 70 kPa environ de pertes de charges dans la plaque froide à 3l/min (comme le montre la figure 8 et l'échelle).

La cible de pertes de charges pour l'équilibrage de lames est de 70kPa. La valeur calculée de la perte de charge globale de la plaque froide est de l'ordre de 75Kpa, ce qui est proche de la valeur cible.

### EXEMPLE 2 : simulation thermique du système de refroidissement selon l'invention à 3 blocs de refroidissement (tel que représenté sur les figures 4 à 7).

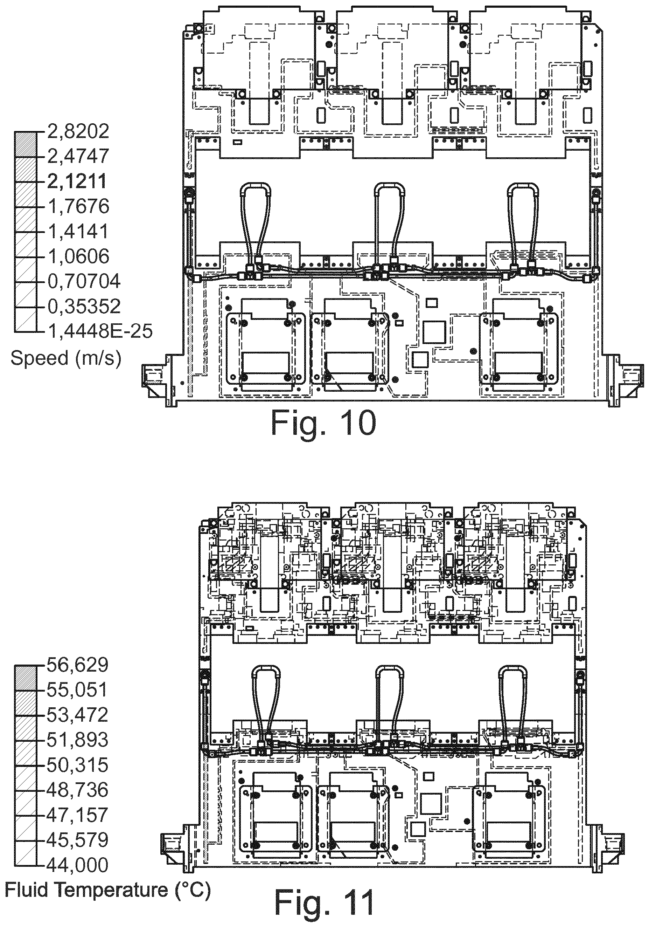

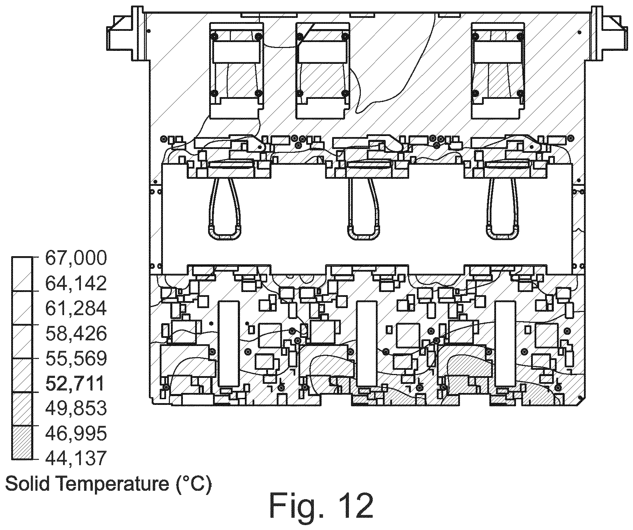

La figure 11 montre le résultat d'une simulation numérique de l'échauffement du fluide caloporteur dans le circuit de refroidissement primaire de la plaque froide, et la figure 12 montre le résultat du champ de températures de la plaque froide (vue de dessous). Des sources de chaleurs sont appliquées directement sur la plaque froide à l'emplacement des composants moyens et bas. Le résultat de la simulation donne une température de plaque à l'interface avec chacun des composants (moyens et bas) .

On observe un échauffement du fluide à l'intérieur de la plaque froide, l'entrée de la plaque froide est bien à 44°C puisque c'est une donnée d'entrée du calcul (condition limite). La sortie est aux alentours de 52°C. On a donc un gradient de température entre l'entrée et la sortie du fluide de 8°C environ.

## Revendications

1. Système de refroidissement liquide (1) d'une carte électronique (2) comprenant un support (21), une pluralité de composants électroniques (22, 23) fixés sur ledit support (21) se décomposant en composants électroniques bas et moyens (22) et en composants électroniques hauts (23), ledit système (1) comprenant :
• une plaque froide (11) présentant des dimensions extérieures sensiblement égales à celles dudit support (21) de la carte électronique (2) de sorte qu'elle recouvre l'intégralité du support (21) et lesdits composants électroniques bas et moyens (22), ladite plaque froide (11) étant une plaque réalisée en un matériau thermique conducteur et comprenant un circuit primaire de refroidissement (110) avec des canaux principaux (1101) à l'intérieur desquels circule un fluide caloporteur (112), l'alimentation en fluide caloporteur (112) dans ladite plaque froide (11) étant réalisée via un connecteur d'entrée (113) et la sortie dudit fluide caloporteur (112) hors de la plaque froide (11) se faisant via un connecteur de sortie (114),
• une pluralité de dissipateurs thermiques (12) comprenant chacun une zone d'échange thermique principale (121) apte à venir en appui contre un composant électronique haut (23),
ledit système de refroidissement liquide (1) étant **caractérisé en ce qu'**il comporte en outre un circuit secondaire (111) de canaux secondaires flexibles (1111) connectés au canaux principaux (1101) du circuit primaire (111) par des connecteurs coudés (1112) fixés dans ladite plaque froide (11), et
**en ce que** lesdits dissipateurs thermiques (12) sont des dissipateurs thermiques monophasiques qui comprennent chacun :
▪ un bloc de refroidissement (120) en matériau thermoconducteur comprenant une partie inférieure constituant la zone d'échange thermique principale (121), une partie intermédiaire (122) dite de répartition et une partie supérieure (123) connectée à la plaque froide (11),
▪ un canal d'entrée (3) et un canal de sortie (4) qui sont connectés d'une part à la partie supérieure (123) dudit bloc de refroidissement (120) par l'intermédiaire respectivement d'un connecteur d'entrée (5) et d'un connecteur de sortie (6), et d'autre part à un canal secondaire flexible (1111) du circuit secondaire (111) via un connecteur coudé (1223, 1224), de sorte que ledit bloc de refroidissement (120) est alimenté par ledit fluide caloporteur (112) circulant dans ladite plaque froide (11), lesdits connecteurs coudés (1223, 1224) étant aptes à permettre la rotation desdits canaux d'entrée et de sortie (3, 4) par rapport audit canal secondaire flexible (1111) auquel ils sont connectés, et
**en ce que** le bloc de refroidissement (120) comprend en outre:
▪ une fente traversante (8) située dans la partie intermédiaire (122) pour répartir de manière homogène l'écoulement dudit fluide caloporteur (112) en provenance de la partie supérieure (123) sous forme de jet centré vers
▪ une plaque support (9) située dans la zone d'échange thermique principale (121) et comportant une partie centrale creuse avec une zone munie d'ailettes (910) pour générer de la turbulence dans le régime d'écoulement dudit fluide caloporteur (112) et une zone périphérique (911) à ladite zone munie d'ailettes (910) pour recueillir le fluide caloporteur (112) et le diriger vers ledit connecteur de sortie (6).

2. Système de refroidissement liquide (1) selon la revendication 1, selon lequel les ailettes (910) sont des ailettes droites.

3. Système de refroidissement liquide (1) selon la revendication 2, selon lequel les ailettes (910) présentent une épaisseur de 0,2 mm et sont espacées les unes des autres d'une distance de 0,4 mm.

4. Système de refroidissement liquide (1) selon l'une quelconque des revendications 1 à 3, selon lequel l'orientation de ladite fente (8) est perpendiculaire à la direction des ailettes (910).

5. Système de refroidissement liquide (1) selon l'une quelconque des revendications 1 à 4, selon lequel la partie intermédiaire (122) est constituée d'une plaque de répartition (7) dans laquelle est pratiquée la fente traversante (8).

6. Système de refroidissement liquide (1) selon la revendication 5, selon lequel ladite plaque de répartition (7) se présente sous la forme sensiblement d'un parallélépipède rectangle dont l'un des côtés est muni d'une marche (71) s'emboitant dans la partie de la zone périphérique (911) de la zone d'échange thermique principale (121) située sous ledit connecteur d'entrée (5), sans recouvrir la partie de la zone périphérique (911) située sous ledit connecteur de sortie (6).

7. Système de refroidissement liquide (1) selon l'une quelconque des revendications précédentes, selon lequel composants électroniques hauts (23) sont des processeurs.

## Patentansprüche

1. Flüssigkeitskühlsystem (1) einer Elektronikplatine (2) mit einem Träger (21), wobei eine Vielzahl elektronischer Bauelemente (22, 23), die auf dem Träger (21) befestigt sind, in niedrige und mittlere elektronische Bauelemente (22) sowie hohe elektronische Bauelemente (23) unterteilt sind, wobei das System (1) Folgendes umfasst:
• eine Kaltplatte (11) mit äußeren Abmessungen, die im Wesentlichen gleich denen des Trägers (21) der Elektronikplatine (2) sind, so dass sie die Gesamtheit des Trägers (21) und der niedrigen und mittleren elektronischen Bauelemente (22) abdeckt, wobei die Kaltplatte (11) eine Platte ist, die aus einem wärmeleitenden Material hergestellt ist und einen primären Kühlkreis (110) mit Hauptkanälen (1101) umfasst, in denen eine Wärmeübertragungsflüssigkeit (112) zirkuliert, wobei die Zufuhr von Wärmeübertragungsflüssigkeit (112) in die Kaltplatte (11) über ein Einlassverbindungsstück (113) und der Austritt der Wärmeübertragungsflüssigkeit (112) aus der Kaltplatte (11) über ein Auslassverbindungsstück (114) erfolgt,
• eine Vielzahl von Kühlkörpern (12), die jeweils eine Hauptwärmetauschzone (121) umfassen, die geeignet ist, um an einem hohen elektronischen Bauelement (23) anzuliegen,
wobei das Flüssigkeitskühlsystem (1) **dadurch gekennzeichnet ist, dass** es ferner einen Sekundärkreis (111) aus flexiblen Sekundärkanälen (1111) umfasst, die mit den Hauptkanälen (1101) des Primärkreises (111) durch in der Kaltplatte (11) befestigte Winkelverbindungsstücke (1112) verbunden sind, und
dass die Kühlkörper (12) einphasige Kühlkörper sind, die jeweils umfassen:
▪ einen Kühlblock (120) aus wärmeleitendem Material mit einem unteren Teil, der die Hauptwärmetauschzone (121) bildet, einem sogenannten Verteilungszwischenteil (122) und einem oberen Teil (123), das mit der Kaltplatte (11) verbunden ist,
▪ einen Einlasskanal (3) und einen Auslasskanal (4), die einerseits mit dem oberen Teil (123) des Kühlblocks (120) über ein Einlassverbindungsstück (5) bzw. ein Auslassverbindungsstück (6) und andererseits mit einem flexiblen Sekundärkanal (1111) des Sekundärkreises (111) über ein Winkelverbindungsstück (1223, 1224) verbunden sind, so dass der Kühlblock (120) mit der Wärmeübertragungsflüssigkeit (112) versorgt wird, die in der Kaltplatte (11) zirkuliert, wobei die Winkelverbindungsstücke (1223, 1224) geeignet sind, um die Drehung des Ein- und Auslasskanals (3, 4) in Bezug zu dem flexiblen Sekundärkanal (1111) zu ermöglichen, mit dem sie verbunden sind, und
dass der Kühlblock (120) ferner umfasst:
▪ einen Durchgangsschlitz (8), der im Zwischenteil (122) angeordnet ist, um den Strom der Wärmeübertragungsflüssigkeit (112) vom oberen Teil (123) in Form eines zentrierten Strahls gleichmäßig zu verteilen in Richtung
▪ einer Trägerplatte (9), die in der Hauptwärmetauschzone (121) angeordnet ist und einen hohlen zentralen Teil mit einer gerippten Zone (910) umfasst, um Turbulenzen im Strömungsbereich der Wärmeübertragungsflüssigkeit (112) und eine Umfangszone (911) um die gerippte Zone (910) zum Sammeln der Wärmeübertragungsflüssigkeit (112) und zum Leiten derselben zum Auslassverbindungsstück (6) zu erzeugen.

2. Flüssigkeitskühlsystem (1) nach Anspruch 1, wobei die Rippen (910) gerade Rippen sind.

3. Flüssigkeitskühlsystem (1) nach Anspruch 2, wobei die Rippen (910) eine Dicke von 0,2 mm aufweisen und einen Abstand von 0,4 mm zueinander haben.

4. Flüssigkeitskühlsystem (1) nach einem der Ansprüche 1 bis 3, wobei die Ausrichtung des Schlitzes (8) senkrecht zur Richtung der Rippen (910) ist.

5. Flüssigkeitskühlsystem (1) nach einem der Ansprüche 1 bis 4, wobei das Zwischenteil (122) aus einer Verteilerplatte (7) besteht, in die der Durchgangsschlitz (8) eingelassen ist.

6. Flüssigkeitskühlsystem (1) nach Anspruch 5, wobei die Verteilerplatte (7) die Form eines im Wesentlichen rechteckigen Parallelepipeds hat, dessen eine Seite mit einer Stufe (71) versehen ist, die in den Teil der Umfangszone (911) der Hauptwärmetauschzone (121) passt, der sich unter dem Einlassverbindungsstück (5) befindet, ohne den Teil der Umfangszone (911) zu bedecken, der sich unter dem Auslassverbindungsstück (6) befindet.

7. Flüssigkeitskühlsystem (1) nach einem der vorstehenden Ansprüche, wobei die hohen elektronischen Bauelemente (23) Prozessoren sind.

## Claims

1. A liquid cooling system (1) for an electronic board (2) comprising a substrate (21), a plurality of electronic components (22, 23) secured to said substrate (21) broken down into low-level and mid-level electronic components (22) and into high-level electronic components (23), said system (1) comprising:
• a cold plate (11) having external dimensions substantially equal to those of said substrate (21) of the electronic board (2) such that it covers the entire substrate (21) and said low-level and mid-level electronic components (22), said cold plate (11) being a plate made from a heat conducting material and comprising a primary cooling circuit (110) with main channels (1101) inside which a heat transfer fluid (112) flows, the supply of heat transfer fluid (112) in said cold plate (11) being done via an inlet connector (113) and the exit of said heat transfer fluid (112) from the cold plate (11) being done via an outlet connector (114),
• a plurality of heat sinks (12) each comprising a main heat exchange zone (121) able to bear against a high-level electronic component (23),
said liquid cooling system (1) being **characterized in that** it further includes a secondary circuit (111) of flexible secondary channels (1111) connected to the main channels (1101) of the primary circuit (111) by angled connectors (1112) secured in said cold plate (11), and
**in that** said heat sinks (12) are single-phase heat sinks which each comprise:
▪ a cooling block (120) made from a heat conducting material comprising a lower part making up the main heat exchange zone (121), an intermediate part (122) called the distribution part and an upper part (123) connected to the cold plate (11),
▪ an inlet channel (3) and an outlet channel (4) which are connected on the one hand to the upper part (123) of said cooling block (120) respectively by means of an inlet connector (5) and of an outlet connector (6), and on the other hand to a flexible secondary channel (1111) of the secondary circuit (111) via an angled connector (1223, 1224), such that said cooling block (120) is supplied by said heat transfer fluid (112) flowing in said cold plate (11), said angled connectors (1223, 1224) being able to allow the rotation of said inlet and outlet channels (3, 4) relative to said flexible secondary channel (1111) to which they are connected, and
**in that** the cooling block (120) further comprises:
▪ a through slot (8) located in the intermediate part (122) to uniformly distribute the flow of said heat transfer fluid (112) coming from the upper part (123) in the form of a centered jet toward
▪ a support plate (9) located in the main heat exchange zone (121) and including a hollow central part with a zone provided with fins (910) in order to generate turbulence in the flow state of said heat transfer fluid (112) and a zone (911) peripheral to said zone provided with fins (910) to collect the heat transfer fluid (112) and orient it toward said outlet connector (6).

2. The liquid cooling system (1) according to claim 1, wherein the fins (910) are straight fins.

3. The liquid cooling system (1) according to claim 2, wherein the fins (910) have a thickness of 0.2 mm and are spaced apart from one another by a distance of 0.4 mm.

4. The liquid cooling system (1) according to any one of claims 1 to 3, wherein the orientation of said slot (8) is perpendicular to the direction of the fins (910).

5. The liquid cooling system (1) according to any one of claims 1 to 4, wherein the intermediate part (122) is made up of a distribution plate (7) in which the through slot (8) is formed.

6. The liquid cooling system (1) according to claim 5, wherein said distribution plate (7) is in the approximate form of a rectangular parallelepiped, one of the sides of which is provided with a step (71) that fits into the part of the peripheral zone (911) of the main heat exchange zone (121) located below said inlet connector (5), without covering the part of the peripheral zone (911) located below said outlet connector (6).

7. The liquid cooling system (1) according to any one of the preceding claims, wherein high-level electronic components (23) are processors.
